# EUROPEAN PATENT SPECIFICATION

(11) **EP 2 922 379 B1**
(45) Date of publication and mention of the grant of the patent: **03.07.2019**
(21) Application number: 12888481.4
(22) Date of filing: 15.11.2012
(51) Int. Cl.: H05K 13/04

(54) **COMPONENT MOUNTING MACHINE**
MASCHINE ZUR MONTAGE VON KOMPONENTEN
MACHINE DE MONTAGE DE COMPOSANT

(43) Date of publication of application: 23.09.2015
(73) Proprietor: FUJI Corporation, Chiryu Aichi (JP)
(72) Inventor: NISHIYAMA, Satoru, Chiryu Aichi (JP)
(74) Representative: Grünecker Patent- und Rechtsanwälte PartG mbB
(86) International application number: PCT/JP2012/079619
(87) International publication number: WO 2014/076790

(56) References cited:
- EP-A1- 2 890 229
- JP-A- H 114 099
- JP-A- H1 197 897
- JP-A- H06 209 192
- JP-A- H09 167 898
- JP-A- 2004 225 732
- JP-A- 2012 134 258
- US-A- 6 154 954

## Description

### Technical Field

The present invention relates to a component mounting machine which is provided to be able to lower a plurality of nozzle holders with a predetermined interval to a rotary head in a circumferential direction thereof.

### Background Art

As described in PTL 1 (JP-A-2004-39818), a rotary head type component mounting machine which is provided to be able to lower a plurality of nozzle holders with a predetermined interval to a rotary head in a circumferential direction thereof, turns the plurality of nozzle holders in the circumferential direction of the rotary head integrally with a plurality of suction nozzles held by the plurality of nozzle holders by holding each suction nozzle downward by each nozzle holder and by rotating the rotary head around an R axis (vertical axis) by an R-axis driving mechanism, and corrects a direction (angle) of each component which is sucked by each suction nozzle held by each nozzle holder by performing suction and mounting of a component by lowering one nozzle holder by a Z-axis driving mechanism at a predetermined position of a turning track and by rotating each nozzle holder around an axial line thereof by an Q-axis driving mechanism.

The prior art in document EP 2 890 229 A1 (PTL 2) discloses a component mounting device with a component suction device which is moved by a head moving mechanism, including: a rotary head which is provided to be rotatable around an R axis which extends in a vertical direction; a plurality of nozzle holders which are held to be lowerable with a predetermined interval to the rotary head in a circumferential direction thereof; a plurality of suction nozzles which are respectively held downward by the plurality of nozzle holders and suck components; an R-axis driving mechanism which turns the plurality of nozzle holders in the circumferential direction of the rotary head integrally with the plurality of suction nozzles by rotating the rotary head around the R axis; and a Q-axis driving mechanism which corrects a direction of each component which is sucked by each suction nozzle held by each nozzle holder by rotating each of the plural nozzle holders around an axial line of each nozzle holder, wherein a driving unit in which the R-axis driving mechanism and the Q-axis driving mechanism are assembled is attached to the head moving mechanism, wherein the rotary head in which the plurality of nozzle holders are held is attachably and detachably linked to the driving unit, wherein, in the rotary head, a nozzle rotation gear mechanism which transfers a rotating force of the Q-axis driving mechanism to each nozzle holder is provided, and wherein, by providing a positioning projection portion in a linking member on one side of a part which links the nozzle rotation gear mechanism and the Q-axis driving mechanism, providing a nipping mechanism which nips the positioning projection portion in a linking member on the other side, and nipping the positioning projection portion by the nipping mechanism, the linking member of the nozzle rotation gear mechanism is linked to the linking member of the Q-axis driving mechanism in a rotating direction by eliminating looseness.

Furthermore, the prior art in document US 6,154,954 A (PTL 3) discloses a component-mounting block of an electronic component-mounting apparatus which has mounting heads installed thereon. Each mounting head has a nozzle-replacing device for replacing at least one selected sucking nozzle by at least one other sucking nozzle to be newly selected. The replacement is possible during travel of the component-mounting block between a mounting position and a sucking position effected by a X-Y moving stage. At least one mounting head carries at least one sucking nozzle rotatable about a vertical axis of a nozzle holder. The mounting head has the nozzle holder, and an engaging member holder. Sucking nozzles are circumferentially arranged about the vertical axis of the nozzle holder and vertically retractably held by the nozzle holder. The engaging member holder holds engaging members which engageably face the nozzles. The nozzles are engaged with the engaging members when the holders are relatively vertically moved toward each other, and are retracted when the holders are moved away from each other. The engagement can be prevented. A selected engaging member is prevented from engaging with a corresponding sucking nozzle by rotating the holders about the vertical axis. Alternatively, at least one nozzle is disengaged from a corresponding engaging member at a desired rotational angle of the holders.

### Citation List

### Patent Literature

PTL 1: JP-A-2004-39818
PTL 2: EP 2 890 229 A1
PTL 3: US 6,154,954 A

### Summary of Invention

### Technical Problem

In a suction nozzle which is held by a nozzle holder, it is necessary to use a suction nozzle which has an appropriate diameter dimension and a shape of a pad in accordance with a type (a size or a shape) of a component to be sucked. For this reason, since the suction nozzles which are held by the nozzle holder can be replaced in accordance with the type of the components to be sucked, but a rotary head cannot be replaced, types (sizes or shapes) of the suction nozzles which can be attached to the nozzle holder assembled to the rotary head are limited, and the types of components which can be sucked are limited.

In order to solve this problem, the inventors have studied a configuration in which the rotary head is attached to be replaceable to a head moving mechanism of a component mounting machine. However, when a configuration in which the entire component suction device which includes the rotary head and a driving unit, such as an R-axis driving mechanism or a Q-axis driving mechanism, is detached from the head moving mechanism of the component mounting machine and automatically replaced is employed, the device part to be replaced becomes larger and more expensive.

Here, the inventors have studied a configuration in which the rotary head is attachable and detachable to be separated from the driving unit, and the driving unit which is common to all of the rotary heads to be replaced can be used. However, in this case, when the rotary head is linked to the driving unit, in order to ensure the positional accuracy of the rotary head in a rotating direction, it is necessary to link a nozzle rotation gear mechanism of the rotary head to the Q-axis driving mechanism of the driving unit without generating looseness (gap), and to newly develop a linking structure to realize this linking.

### Solution to Problem

In order to solve the above-described problem, the present invention provides a component mounting machine, including a component suction device which is moved by a head moving mechanism, the component suction device including: a rotary head which is provided to be rotatable around an R axis which extends in a vertical direction; a plurality of nozzle holders which are held to be lowerable with a predetermined interval to the rotary head in a circumferential direction thereof; a plurality of suction nozzles which are respectively held downward by the plurality of nozzle holders and suck components; an R-axis driving mechanism which turns the plurality of nozzle holders in the circumferential direction of the rotary head integrally with the plurality of suction nozzles by rotating the rotary head around the R axis; and a Q-axis driving mechanism which corrects a direction of each component which is sucked by each suction nozzle held by each nozzle holder by rotating each of the plural nozzle holders around an axial line of each nozzle holder. A driving unit in which the R-axis driving mechanism and the Q-axis driving mechanism are assembled is attached to the head moving mechanism. The rotary head in which the plurality of nozzle holders are held is attachably and detachably linked to the driving unit. In the rotary head, a nozzle rotation gear mechanism which transfers a rotating force of the Q-axis driving mechanism to each nozzle holder is provided. By providing a positioning projection portion in a linking member on one side of a part which links the nozzle rotation gear mechanism and the Q-axis driving mechanism, providing a nipping mechanism which nips the positioning projection portion in a linking member on the other side, and nipping the positioning projection portion by the nipping mechanism, the linking member of the nozzle rotation gear mechanism is linked to the linking member of the Q-axis driving mechanism in a rotating direction by eliminating looseness.

In this configuration, since the positioning projection portion which is provided in the linking member on one side of the part which links the nozzle rotation gear mechanism and the Q-axis driving mechanism is nipped by the nipping mechanism which is provided in the linking member on the other side, it is possible to link the nozzle rotation gear mechanism of the rotary head to the Q-axis driving mechanism of the driving unit without generating looseness. Furthermore, since it is possible to attach and detach the rotary head to be separated from the driving unit of the component suction device, it is possible to use the driving unit which is common to all of the rotary heads to be replaced. Accordingly, it is not necessary to assemble the driving unit to the rotary head to be replaced, and it is possible to realize a small size and low cost of the rotary head to be replaced and to save replacement work space.

In this case, the nipping mechanism may be configured of a reference roller of which a position is fixed, a movable roller of which an interval with the reference roller is changed, and a bias unit which biases the movable roller in a direction of the reference roller, and the positioning projection portion may be nipped between the reference roller and the movable roller. According to this, when the positioning projection portion is inserted between the reference roller and the movable roller, it is possible to easily insert the positioning projection portion by the rotation of both rollers, to position and nip the positioning projection portion by considering the reference roller as a reference, and to improve the positional accuracy of the rotary head in a rotating direction.

In addition, in the present invention, a rotary head placing stand which places a rotary head for replacement and a camera which is moved by the head moving mechanism, may be provided. A control device, which controls an operation of the component mounting machine, may image the positioning projection portion or the nipping mechanism of the rotary head which is placed on the rotary head placing stand with the camera, recognize a position of the positioning projection portion or the nipping mechanism, align the positioning projection portion and the nipping mechanism based on the recognition result, and link the driving unit and the rotary head. In this case, even when a gear phase (rotation phase of the gear) of the Q-axis driving mechanism of the rotary head which is placed on the rotary head placing stand of the component mounting machine has any type of phases, it is possible to automatically adjust the gear phase of the Q-axis driving mechanism of the driving unit of the component suction device to the gear phase of the rotary head on the rotary head placing stand, to nip the positioning projection portion by the nipping mechanism, and to link the positioning projection portion.

In this case, the nozzle rotation gear mechanism may rotate each nozzle holder by meshing a cylindrical gear which is held to be rotatable by the rotary head and small gears which are respectively attached to each nozzle holder, and rotating the small gears of each nozzle holder by rotating the cylindrical gear by the Q-axis driving mechanism of the driving unit. Accordingly, the nozzle rotation gear mechanism which transfers the rotating force of the Q-axis driving mechanism of the driving unit to each nozzle holder can be configured of one cylindrical gear and the small gears of each nozzle holder.

In addition, the driving unit may include a Z-axis driving mechanism which lowers the nozzle holder which is rotated to a predetermined position by the rotation of the rotary head. In this case, it is also possible to use the Z-axis driving mechanism which is common to all of the rotary heads to be replaced.

### Brief Description of Drawings

Fig. 1 is a perspective view illustrating a state where a rotary head is detached from a driving unit of a component suction device of an embodiment of the present invention.
Fig. 2 is a perspective view illustrating a state where the rotary head is linked to the driving unit of the component suction device.
Fig. 3 is a front view illustrating a state where a positioning projection portion is nipped between a reference roller and a movable roller of a nipping mechanism.
Fig. 4 is a perspective view of the rotary head.
Fig. 5 is a front view illustrating an operation of recognizing a fiducial mark by imaging the fiducial mark of the rotary head by a camera.
Fig. 6 is an upper view illustrating the operation of recognizing the fiducial mark by imaging the fiducial mark of the rotary head by the camera.
Fig. 7 is a block diagram illustrating a configuration of a control system of a component mounting machine.

### Description of Embodiments

Hereinafter, an embodiment which illustrates a state for realizing the present invention in detail will be described. First, a configuration of a component suction device 10 of a component mounting machine will be described.

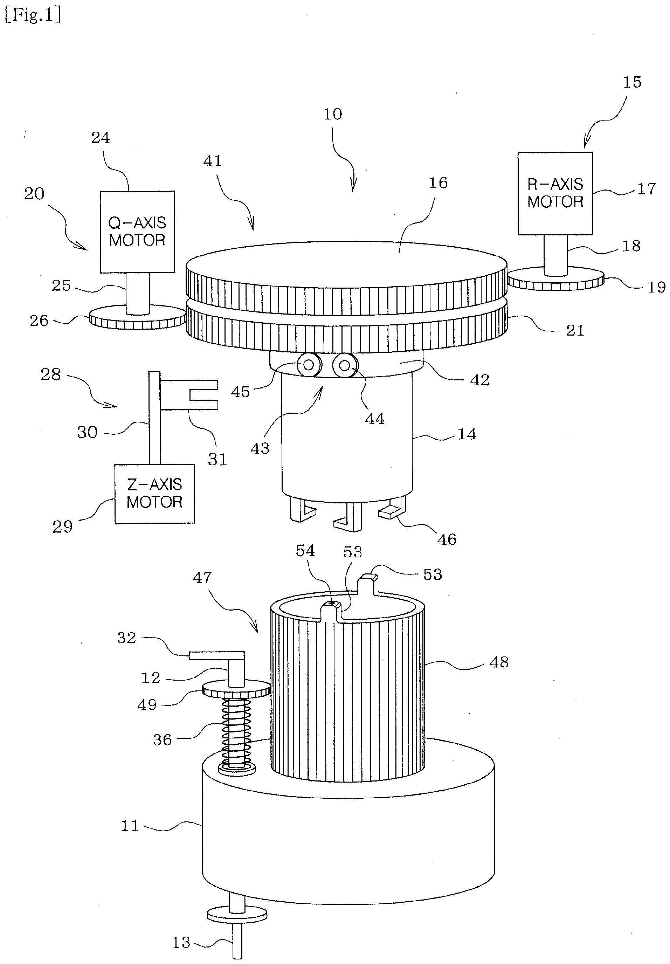

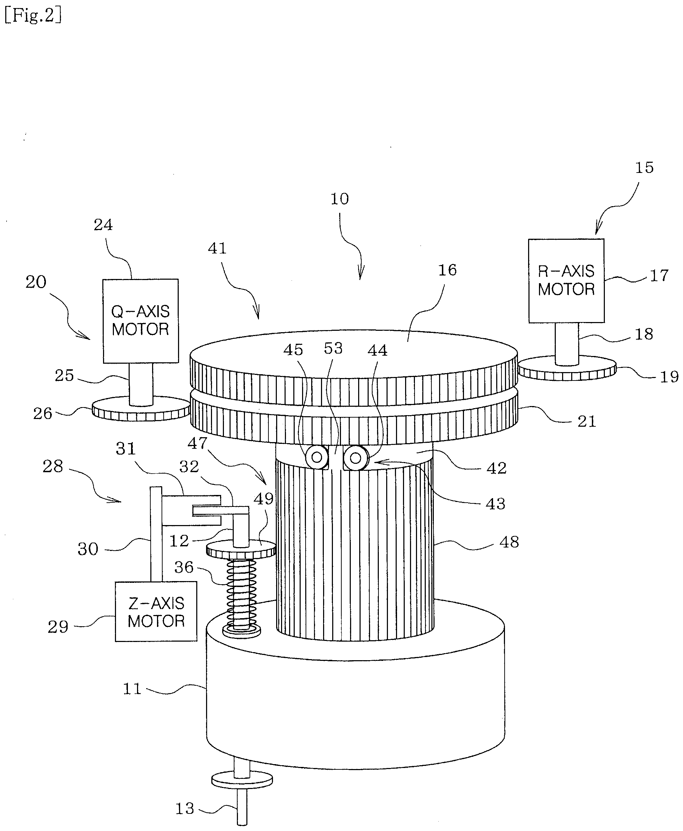

In a rotary head 11 of the component suction device 10, a plurality of nozzle holders 12 are held to be lowerable with a predetermined interval in a circumferential direction thereof, and at lower portions of each nozzle holder 12, a suction nozzle 13 which sucks each component is held downward. Each nozzle holder 12 is biased upward by each spring 36. In addition, in Figs. 1 and 2, only one nozzle holder 12 is illustrated, and other nozzle holders 12 are omitted in the drawings.

The rotary head 11 is linked to be replaceable (attachable and detachable) to an R axis 14 which extends to a lower part of a driving unit 41, and an R-axis gear 16 of an R-axis driving mechanism 15 is fixed to an upper end of the R axis 14 in a concentric shape. A gear 19 which is fixed to a rotation axis 18 of an R-axis motor 17 is meshed with the R-axis gear 16, and as the R-axis gear 16 rotates by the rotation of the gear 19 of the R-axis motor 17 and the rotary head 11 rotates around the R axis 14, the plurality of nozzle holders 12 turn in the circumferential direction of the rotary head 11 integrally with a plurality of suction nozzles 13.

A Q-axis gear 21 of a Q-axis driving mechanism 20 is inserted to be rotatable into the R axis 14, a gear 26 which is fixed to a rotation axis 25 of a Q-axis motor 24 is meshed with the Q-axis gear 21, and the Q-axis gear 21 rotates around the R axis 14 by the rotation of the gear 26 of the Q-axis motor 24. A ring-shaped flange portion 42 (linking member) is provided to be protruded downward on a lower surface of the Q-axis gear 21, and a nipping mechanism 43 which nips a positioning projection portion 53 of a cylindrical gear 48 which will be described later is provided at a predetermined position on an outer circumferential surface of the flange portion 42.

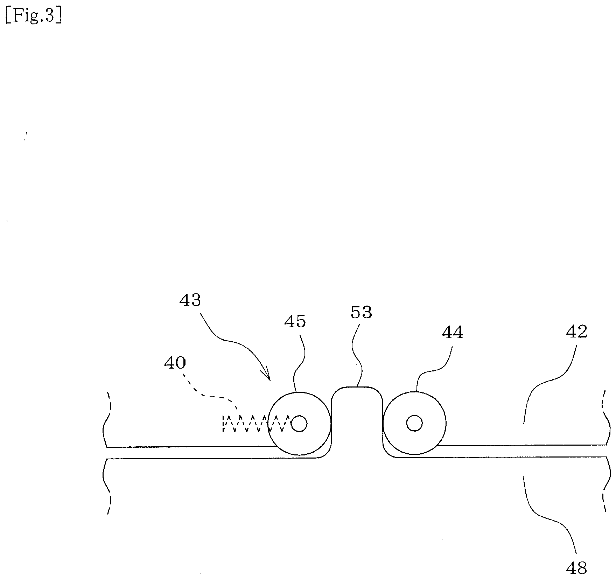

The nipping mechanism 43 is configured of a reference roller 44 of which a position is fixed, a movable roller 45 of which an interval with the reference roller 44 in a horizontal direction (rotating direction of the Q-axis gear 21) is changed, and a spring 40 (refer to Fig. 3) which is a bias unit that biases the movable roller 45 in a direction of the reference roller 44, and the positioning projection portion 53 of the cylindrical gear 48 is nipped between the reference roller 44 and the movable roller 45. In the embodiment, since a plurality (for example, two) of positioning projection portions 53 are provided, the same number of nipping mechanisms 43 as the number of the positioning projection portion 53 are provided at positions which correspond to those of the positioning projection portions 53. Furthermore, in the present invention, a configuration in which one positioning projection portion 53 and one nipping mechanism 43 are provided may be employed.

The R axis 14 functions as a head holding portion which holds the rotary head 11 to be attachable and detachable, a plurality (for example, four) of engaging members 46 for engaging and holding the rotary head 11 to be attachable and detachable are provided to be movable in a vertical direction in a lower end portion of the R axis 14, and an air cylinder (not illustrated) which drives each engaging member 46 in the vertical direction is provided in the vicinity of each engaging member 46. Each engaging member 46 is formed in an L shape or in a J shape, arranged with an equivalent interval in the circumferential direction of the R axis 14, and arranged so that directions of hook portions of each engaging member 46 are the same directions as a regular rotating direction (or a reverse rotating direction) of the R axis 14.

Meanwhile, in the rotary head 11, a nozzle rotation gear mechanism 47 which transfers a rotating force of the Q-axis gear 21 to each nozzle holder 12 is provided. As the nozzle rotation gear mechanism 47 meshes the cylindrical gear 48 which is held to be rotatable in a concentric shape on an upper side of the rotary head 11 and small gears 49 which are respectively attached to each nozzle holder 12, rotates the cylindrical gear 48 by the Q-axis gear 21 of the driving unit 41, and rotates the small gears 49 of each nozzle holder 12, each nozzle holder 12 rotates around the axial line of each nozzle holder 12, and a direction (angle) of each component which is sucked by each suction nozzle 13 held by each nozzle holder 12 is corrected.

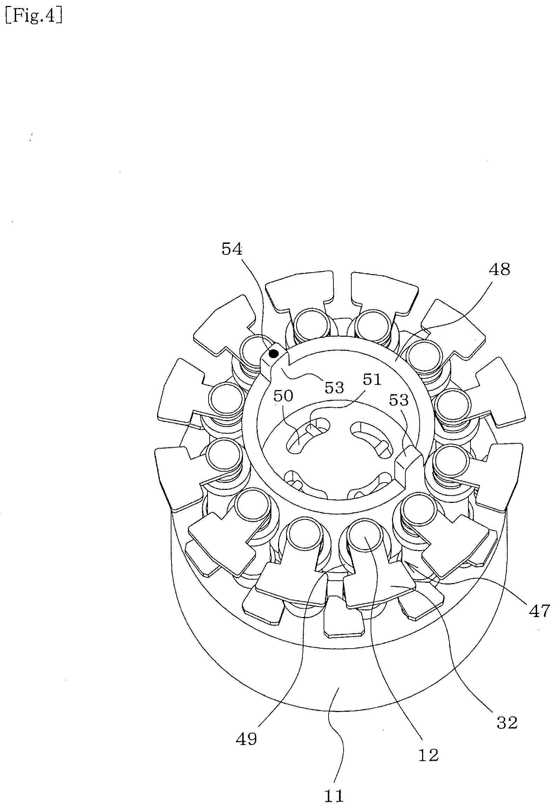

The cylindrical gear 48 is formed so that the R axis 14 can be inserted. As illustrated in Fig. 4, at a position on an inner side of the cylindrical gear 48 in an upper surface portion of the rotary head 11, a plurality of long holes 50 through which each engaging member 46 of the R axis 14 is inserted are formed with an equivalent interval in the circumferential direction, and on one direction side of each long hole 50, an engaged pin 51 (engaged member) with which the hook portion of the engaging member 46 is engaged is fixed to pass in a radial direction of the rotary head 11. On a side of the engaged pin 51 in each long hole 50, a void through which the engaging member 46 slips in the vertical direction is ensured.

When linking the rotary head 11 to the driving unit 41, the R axis 14 is inserted into the cylindrical gear 48, each engaging member 46 of the R axis 14 is inserted through each long hole 50 of the rotary head 11, each engaging member 46 is held to be pulled up in a state where the R axis 14 is rotated by the rotation of the R-axis gear 16 and each engaging member 46 is engaged with the engaged pin 51 in each long hole 50.

In an upper end portion of the cylindrical gear 48 (linking member), the plurality (for example, two) of positioning projection portions 53 are formed to be protruded upward with a predetermined interval. On an upper surface of one positioning projection portion 53 among the plurality of positioning projection portions 53, a fiducial mark 54 (reference position display portion) which displays a reference position of the cylindrical gear 48 is formed.

When linking the rotary head 11 to the driving unit 41, as illustrated in Fig. 2, as each positioning projection portion 53 is nipped to be inserted between the reference roller 44 and the movable roller 45 of each nipping mechanism 43, the cylindrical gear 48 is linked to the Q-axis gear 21 by eliminating looseness in the rotating direction. Accordingly, the Q-axis gear 21 and the cylindrical gear 48 are in a state of rotating integrally, and a gear phase (rotation phase of the Q-axis gear 21) of the driving unit 41 of the component suction device 10 is in a state of being accorded with a gear phase (rotation phase of the cylindrical gear 48) of the rotary head 11 by considering a position of the fiducial mark 54 (positioning projection portion 53) as a reference.

In the driving unit 41, in addition to the R-axis driving mechanism 15 and the Q-axis driving mechanism 20, a Z-axis driving mechanism 28 is assembled, and by the Z-axis driving mechanism 28, the nozzle holder 12 is lowered to a predetermined stop position of a turning track of the nozzle holder 12. The Z-axis driving mechanism 28 engages a Z-axis slide 31 with an engagement piece 32 which is provided at an upper end of the nozzle holder 12 and vertically moves the nozzle holder 12 by using a Z-axis motor 29 as an actuator, rotating a feed screw 30 by the Z-axis motor 29, and moving the Z-axis slide 31 in the vertical direction.

In addition, the Z-axis slide 31 may be moved in the vertical direction by using a linear motor as the Z-axis motor 29. Otherwise, instead of the linear motor, a linear solenoid or an air cylinder may be used. One Z-axis driving mechanism 28 may be provided, and a plurality of Z-axis driving mechanisms 28 may be provided with a predetermined angle interval in the circumferential direction of the rotary head 11.

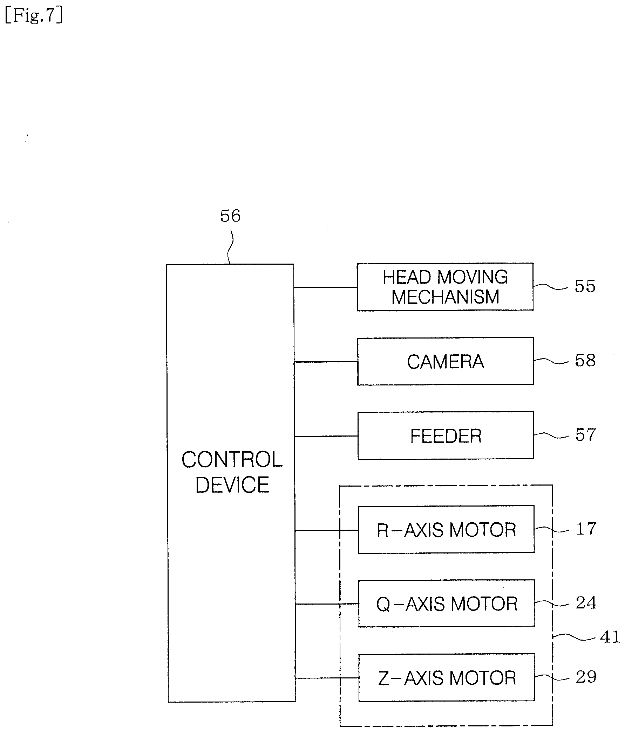

The driving unit 41 of the component suction device 10 which is configured as described above is supported by a head moving mechanism 55 (refer to Fig. 7) of the component mounting machine and moves in an XYZ direction. According to a production program, a control device 56 (control unit) of the component mounting machine controls the head moving mechanism 55, the R-axis motor 17 of the driving unit 41, the Q-axis motor 24, and the Z-axis motor 29, and controls operations of sucking the component supplied from a plurality of feeders 57 by the suction nozzles 13 and mounting the components on a circuit board.

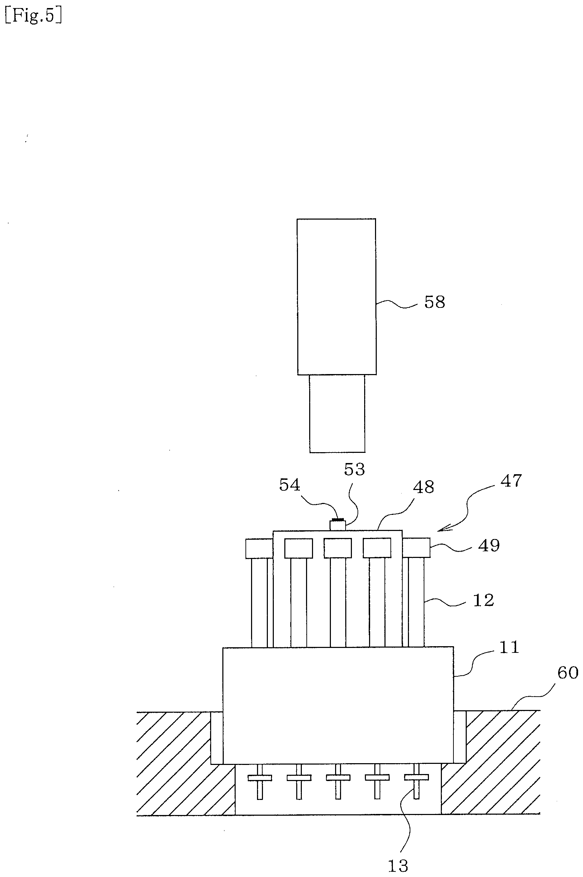

In the component mounting machine, a camera 58 which images the fiducial mark of the circuit board is loaded, and the camera 58 moves being integrated with the component suction device 10 by the head moving mechanism 55. Furthermore, in the component mounting machine, a rotary head placing stand 60 (refer to Fig. 5) which places the rotary head 11 detached from the driving unit 41 is provided. On the rotary head placing stand 60, it is possible to place a plurality of rotary heads 11 for replacement. The camera 58 is used as a camera for imaging the fiducial mark 54 of the rotary head 11 on the rotary head placing stand 60 in addition to the fiducial mark of the circuit board.

Next, a method of linking the rotary head 11 which is place on the rotary head placing stand 60 to the driving unit 41 of the component suction device 10 will be described.

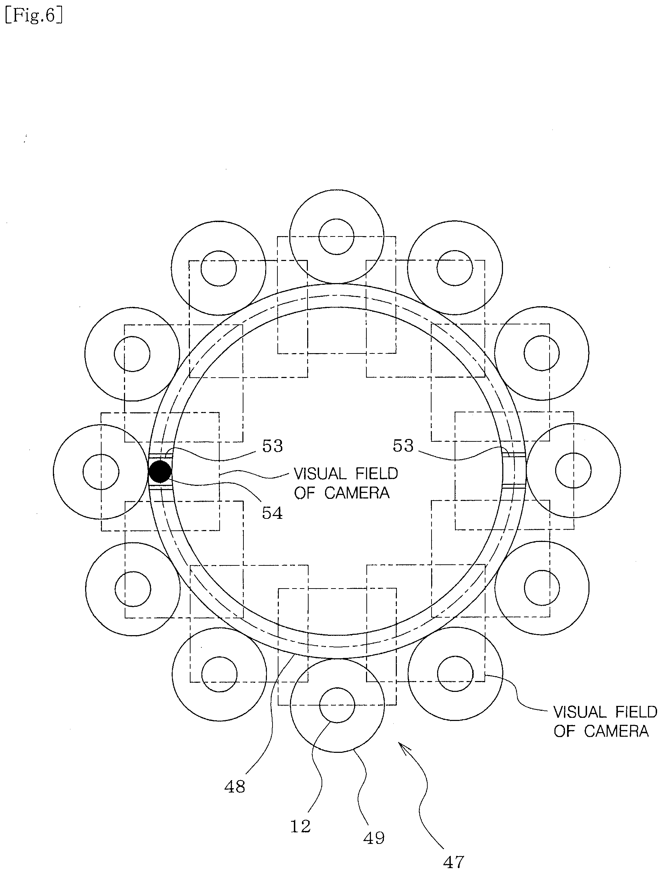

First, as illustrated in Fig. 5, the camera 58 is moved to an upper part of the rotary head 11 which is placed on the rotary head placing stand 60, the upper end portion of the cylindrical gear 48 is imaged by the camera 58, the presence or the absence of the fiducial mark 54 is determined by image processing, and when it is determined that the fiducial mark 54 is not present, the fiducial mark 54 is discovered by repeating the processing of imaging by slightly deviating the position (imaging area) of the camera 58 in the circumferential direction of the cylindrical gear 48, and determining the presence or the absence of the fiducial mark 54 by the image processing (refer to Fig. 6). Accordingly, the position of the fiducial mark 54 (positioning projection portion 53 of the reference position) is detected, and the rotation phase of the cylindrical gear 48 is detected.

After this, the R axis 14 of the driving unit 41 is moved to the upper part of the rotary head 11 by the head moving mechanism 55, and the rotation phase of the Q-axis gear 21 of the driving unit 41 is adjusted to the rotation phase of the cylindrical gear 48 of the rotary head 11 by the Q-axis motor 24. After this, the driving unit 41 is lowered by the head moving mechanism 55, the R axis 14 is inserted into the cylindrical gear 48, and each positioning projection portion 53 of the cylindrical gear 48 is nipped to be thrust between the reference roller 44 and the movable roller 45 of each nipping mechanism 43 of the Q-axis gear 21. At this time, after each engaging member 46 of the R axis 14 is inserted through each long hole 50 of the rotary head 11, and each engaging member 46 is engaged with the engaged pin 51 in each long hole 50 by rotating the R axis 14 by rotating the R-axis gear 16 by the R-axis motor 17, each engaging member 46 is pulled up by the air cylinder (not illustrated) and the engaged state is held. Accordingly, the operation of linking the rotary head 11 to the driving unit 41 is completed.

According to the embodiment described above, in a structure in which the rotary head 11 is attachably and detachably linked to the driving unit 41 of the component suction device 10, since the positioning projection portion 53 on the nozzle rotation gear mechanism 47 side of the rotary head 11 is nipped by the nipping mechanism 43 on the Q-axis driving mechanism 20 side of the driving unit 41, it is possible to link the nozzle rotation gear mechanism 47 of the rotary head 11 to the Q-axis mechanism 43 of the driving unit 41 without generating looseness.

Furthermore, since the nipping mechanism 43 is configured of the reference roller 44 of which the position is fixed, the movable roller 45 of which the interval with the reference roller 44 is changed, and the spring 40 which biases the movable roller 45 in the direction of the reference roller 44, and the positioning projection portion 53 is nipped between the reference roller 44 and the movable roller 45, when inserting the positioning projection portion 53 between the reference roller 44 and the movable roller 45, it is easy to insert the positioning projection portion 53 by the rotation of both rollers 44 and 45, and it is possible to position and nip the positioning projection portion 53 by considering the reference roller 44 as a reference and to improve the positional accuracy of the rotary head 11 in the rotating direction.

In addition, since it is possible to attach and detach the rotary head 11 to be separated from the driving unit 41 of the component suction device 10, it is possible to use the driving unit 41 which is common to all of the rotary heads 11 to be replaced. Accordingly, it is not necessary to assemble the driving unit 41 to the rotary head 11 to be replaced, and it is possible to realize a small size and low cost of the rotary head 11 to be replaced and to save replacement work space. Moreover, since the fiducial mark 54 (positioning projection portion 53) which displays the reference position is provided in the cylindrical gear 48 of the nozzle rotation gear mechanism 47 of the rotary head 11, it is possible to detect the gear phase (gear phase of the nozzle rotation gear mechanism 47) of the rotary head 11 by the position of the fiducial mark 54 (positioning projection portion 53). Accordingly, when linking the rotary head 11 to the driving unit 41 of the component suction device 10, it is possible to accurately adjust the gear phase (rotation phase of the Q-axis gear 21) of the driving unit 41 of the component suction device 10 to the gear phase (rotation phase of the cylindrical gear 48) of the rotary head 11 by considering the position of the fiducial mark 54 (positioning projection portion 53 of the reference position) as a reference.

Moreover, in the embodiment, since the fiducial mark 54 of the rotary head 11 which is placed on the rotary head placing stand 60 is imaged by the camera 58 from above, and a position of the fiducial mark 54 is recognized, the gear phase of the driving unit 41 is adjusted to the gear phase of the rotary head 11 based on the recognition result, and the driving unit 41 is linked to the rotary head 11, even when the gear phase of the rotary head 11 which is placed on the rotary head placing stand 60 of the component mounting machine is any type of gear phase, it is possible to automatically adjust the gear phase of the driving unit 41 of the component suction device 10 to the gear phase of the rotary head 11 on the rotary head placing stand 60, and to link the gear phases. Accordingly, when placing the rotary head 11 onto the rotary head placing stand 60, it is not necessary to adjust the gear phase of the rotary head 11 to a specific phase, and it is possible to simplify the structure of the rotary head placing stand 60 and to realize a low number of components and a low cost of the rotary head placing stand 60.

In addition, in the above-described embodiment, the positioning projection portion 53 is provided on the nozzle rotation gear mechanism 47 side of the rotary head 11, and the nipping mechanism 43 is provided on the Q-axis driving mechanism 20 side of the driving unit 41. However, in contrast, the positioning projection portion may be provided on the Q-axis driving mechanism 20 side of the driving unit 41, and the nipping mechanism 43 may be provided on the nozzle rotation gear mechanism 47 side of the rotary head 11.

In addition, the nipping mechanism 43 is not limited to a configuration in which the rollers 44 and 45 are used, and for example, may have a configuration in which the positioning projection portion 53 is nipped by a spring member.

In addition to this, the present invention is not limited to the above-described embodiment, and it is possible to perform various changes within a range that does not depart from the concept of the invention, for example, a configuration in which the rotary head 11 is held to be engaged with the driving unit 41 may be appropriately changed.

### Reference Signs List

10 ... Component suction device, 11 ... Rotary head, 12 ... Nozzle holder, 13 ... Suction nozzle, 14 ... R axis, 15 ... R-axis driving mechanism, 16 ... R-axis gear, 17 ... R-axis motor, 20 ... Q-axis driving mechanism, 21 ... Q-axis gear, 24 ... Q-axis motor, 28 ... Z-axis driving mechanism, 29 ... Z-axis motor, 30 ... Feed screw, 31 ... Z-axis slide, 32 ... Engagement piece, 40 ... Spring (bias unit), 41 ... Driving unit, 42 ... Flange portion (linking member), 43 ... Nipping mechanism, 44 ... Reference roller, 45 ... Movable roller, 46 ... Engaging member, 47 ... Nozzle rotation gear mechanism, 48 ... Cylindrical gear (linking member), 49 ... Small gear, 50 ... Long hole, 51 ... Engaged pin, 53 ... Positioning projection portion, 54 ... Fiducial mark, 55 ... Head moving mechanism, 56 ... Control device, 58 ... Camera, 60 ... Rotary head placing stand

## Claims

1. A component mounting machine, comprising:
a component suction device (10) which is moved by a head moving mechanism (55), including: a rotary head (11) which is provided to be rotatable around an R axis (14) which extends in a vertical direction; a plurality of nozzle holders (12) which are held to be lowerable with a predetermined interval to the rotary head (11) in a circumferential direction thereof; a plurality of suction nozzles (13) which are respectively held downward by the plurality of nozzle holders (12) and suck components; an R-axis driving mechanism (15) which turns the plurality of nozzle holders (12) in the circumferential direction of the rotary head (11) integrally with the plurality of suction nozzles (13) by rotating the rotary head (11) around the R axis (14); and a Q-axis driving mechanism (20) which corrects a direction of each component which is sucked by each suction nozzle (13) held by each nozzle holder (12) by rotating each of the plural nozzle holders (12) around an axial line of each nozzle holder (12),
wherein a driving unit (41) in which the R-axis driving mechanism (15) and the Q-axis driving mechanism (20) are assembled is attached to the head moving mechanism (55),
wherein the rotary head (11) in which the plurality of nozzle holders (12) are held is attachably and detachably linked to the driving unit (41),
wherein, in the rotary head (11), a nozzle rotation gear mechanism (47) which transfers a rotating force of the Q-axis driving mechanism (20) to each nozzle holder (12) is provided, and
wherein, by providing a positioning projection portion (53) in a linking member (48) on one side of a part which links the nozzle rotation gear mechanism (47) and the Q-axis driving mechanism (20), providing a nipping mechanism (43) which nips the positioning projection portion (53) in a linking member (42) on the other side, and nipping the positioning projection portion (53) by the nipping mechanism (43), the nipping mechanism (43) including a reference roller (44) of which a position is fixed, a movable roller (45) of which an interval with the reference roller (44) is changed, and a bias unit (40) which biases the movable roller (45) in a direction of the reference roller (44), and the positioning projection portion (53) is nipped between the reference roller (44) and the movable roller (45), the linking member (48) of the nozzle rotation gear mechanism (47) is linked to the linking member (42) of the Q-axis driving mechanism (20) in a rotating direction by eliminating looseness.

2. The component mounting machine according to Claim 1, further comprising:
a rotary head placing stand (60) which places a rotary head (11) for replacement; and
a camera (58) which is moved by the head moving mechanism (55),
wherein a control device (56), which controls an operation of the component mounting machine, images the positioning projection portion (53) or the nipping mechanism (43) of the rotary head (11) which is placed on the rotary head placing stand (60) with the camera (58), recognizes a position of the positioning projection portion (53) or the nipping mechanism (43), aligns the positioning projection portion (53) and the nipping mechanism (43) based on the recognition result, and links the driving unit (41) and the rotary head (11).

3. The component mounting machine according to any one of Claims 1 or 2,
wherein the nozzle rotation gear mechanism (47) rotates each nozzle holder (12) by meshing a cylindrical gear (48) which is held to be rotatable by the rotary head (11) and small gears (49) which are respectively attached to each nozzle holder (12), and rotating the small gears (49) of each nozzle holder (12) by rotating the cylindrical gear (48) by the Q-axis driving mechanism (20) of the driving unit (41).

4. The component mounting machine according to any one of Claims 1 to 3,
wherein the driving unit (41) includes a Z-axis driving mechanism (28) which lowers the nozzle holder (12) which is rotated to a predetermined position by the rotation of the rotary head (11).

## Patentansprüche

1. Maschine zum Montieren von Bauteilen, die umfasst:
eine Bauteil-Ansaugvorrichtung (10), die durch einen Kopf-Bewegungsmechanismus (55) bewegt wird, der einen Dreh-Kopf (11), der um eine R-Achse (14) herum gedreht werden kann, die in einer vertikalen Richtung verläuft, eine Vielzahl von Düsen-Haltern (12), die so gehalten werden, dass sie mit einem vorgegebenen Abstand zu dem Dreh-Kopf (11) in einer Umfangsrichtung desselben abgesenkt werden können, eine Vielzahl von Saugdüsen (13), die jeweils durch die Vielzahl von Düsen-Haltern (12) nach unten gehalten werden und Bauteile ansaugen, einen R-Achsen-Antriebsmechanismus (15), der die Vielzahl von Düsen-Haltern (12) in der Umfangsrichtung des Dreh-Kopfes (11) integral mit der Vielzahl von Saugdüsen (13) umdreht, indem er den Dreh-Kopf (11) um die R-Achse (14) herum dreht, sowie einen Q-Achsen-Antriebsmechanismus (20) enthält, der eine Richtung jedes Bauteils korrigiert, das durch jede von jedem Düsen-Halter (12) gehaltene Saugdüse (13) angesaugt wird, indem er jeden der Vielzahl von Düsen-Haltern (12) um eine axiale Linie jedes Düsen-Halters (12) herum dreht,
wobei eine Antriebs-Einheit (41), in der der R-Achsen-Antriebsmechanismus (15) und der Q-Achsen-Antriebsmechanismus (20) zusammengesetzt sind, an dem Kopf-Bewegungsmechanismus (55) angebracht ist,
der Dreh-Kopf (11), in dem die Vielzahl von Düsen-Haltern (12) gehalten werden, so mit der Antriebs-Einheit (41) verbunden ist, dass er angebracht und abgenommen werden kann,
in dem Dreh-Kopf (11) ein Zahnradmechanismus (47) für Düsen-Drehung vorhanden ist, der eine Drehkraft des Q-Achsen-Antriebsmechanismus (20) auf jeden Düsen-Halter (12) überträgt, und
wobei, indem ein Positionier-Vorsprungsabschnitt (53) an einem Verbindungs-Element (48) an einer Seite eines Teils vorgesehen wird, der den Zahnradmechanismus (47) für Düsen-Drehung und den Q-Achsen-Antriebsmechanismus (20) verbindet, ein Klemmmechanismus (43), der den Positionier-Vorsprungsabschnitt (53) einklemmt in einem Element (42) an der anderen Seite vorgesehen wird und der Positionier-Vorsprungsabschnitt (53) mit dem Klemmmechanismus (43) festgeklemmt wird, wobei der Klemmmechanismus (43) eine Bezugs-Rolle (44), deren Position unveränderlich ist, eine bewegliche Rolle (45) deren Abstand zu der Bezugs-Rolle (44) geändert wird, sowie eine Spann-Einheit (40) enthält, die die bewegliche Rolle (45) in einer Richtung der Bezugs-Rolle (44) spannt, und der Positionier-Vorsprungsabschnitt (53) zwischen der Bezugs-Rolle (44) und der beweglichen Rolle (45) eingeklemmt wird, das Verbindungs-Element (48) des Zahnradmechanismus (47) für Düsen-Drehung mit dem Verbindungs-Element (42) des Q-Achsen-Antriebsmechanismus (20) in einer Drehrichtung verbunden wird, indem Spiel aufgehoben wird.

2. Maschine zum Montieren von Bauteilen nach Anspruch 1, die des Weiteren umfasst:
einen Untersatz (60) zum Aufsetzen des Dreh-Kopfes, auf den ein Dreh-Kopf (11) zum Austausch aufgesetzt wird; und
eine Kamera (58), die durch den Kopf-Bewegungsmechanismus (55) bewegt wird,
wobei eine Steuerungseinrichtung (56), die eine Funktion der Maschine zum Montieren von Bauteilen steuert, den Positionier-Vorsprungsabschnitt (53) oder den Klemmmechanismus (43) des Dreh-Kopfes (11), der auf den Untersatz (60) zum Aufsetzen des Dreh-Kopfes aufgesetzt ist, mit der Kamera (58) abbildet, eine Position des Positionier-Vorsprungsabschnitts (53) oder des Klemmmechanismus (53) erkennt, den Positionier-Vorsprungsabschnitt (53) und den Klemmmechanismus (43) auf Basis des Ergebnisses der Erkennung ausrichtet und die Antriebs-Einheit (41) und den Dreh-Kopf (11) verbindet.

3. Maschine zum Montieren von Bauteilen nach einem der Ansprüche 1 oder 2,
wobei der Zahnradmechanismus (47) für Düsen-Drehung jeden Düsen-Halter (12) durch Kämmen eines Stirnrades (48), das so gehalten wird, dass es von dem Dreh-Kopf (11) gedreht werden kann, mit Ritzeln (59), die jeweils an jedem Düsen-Halter (12) angebracht sind, und Drehen der Ritzel (49) jedes Düsen-Halters (12) durch Drehen des Stirnrades (48) mit dem Q-Achsen-Antriebsmechanismus (20) der Antriebs-Einheit (41) dreht.

4. Maschine zum Montieren von Bauteilen nach einem der Ansprüche 1 bis 3,
wobei die Antriebs-Einheit (41) einen Z-Achsen-Antriebsmechanismus (28) enthält, der den Düsen-Halter (12) absenkt, der durch die Drehung des Dreh-Kopfes (11) an eine vorgegebene Position gedreht wird.

## Revendications

1. Machine de montage de composants, comprenant :
un dispositif de succion de composant (10) qui est déplacé par un mécanisme de déplacement de tête (55), comprenant : une tête rotative (11) pourvue pour être rotative autour d'un axe R (14) qui s'étend en direction verticale ; une pluralité de supports de buse (12) montés de manière à pouvoir s'abaisser avec un intervalle prédéterminé par rapport à la tête rotative (11) en direction circonférentielle de celle-ci ; une pluralité de buses de succion (13) maintenues respectivement vers le bas par la pluralité de supports de buse (12) et de composants d'aspiration ; un mécanisme d'entraînement d'axe R (15) qui fait tourner la pluralité de supports de buse (12) en direction circonférentielle de la tête rotative (11) conjointement à la pluralité de buses de succion (13) en faisant tourner la tête rotative (11) autour de l'axe R (14) ; et un mécanisme d'entraînement d'axe Q (20) qui corrige la direction de chaque composant qui est aspiré par chaque buse de succion (13) maintenue par chaque support de buse (12) en faisant tourner chaque support de la pluralité de supports de buse (12) autour d'une ligne axiale de chaque support de buse (12),
dans laquelle une unité d'entraînement (41), où le mécanisme d'entraînement d'axe R (15) et le mécanisme d'entraînement d'axe Q (20) sont assemblés, est attachée au mécanisme de déplacement de tête (55),
dans laquelle la tête rotative (11), où la pluralité de supports de buse (12) sont maintenus, est reliée de manière attachable et détachable à l'unité d'entraînement (41),
dans laquelle, dans la tête rotative (11), est pourvu un mécanisme à engrenages de rotation de buse (47) qui transfère une force de rotation du mécanisme d'entraînement d'axe Q (20) à chaque support de buse (12), et
dans laquelle, en fournissant une portion de projection de positionnement (53) dans un élément de liaison (48) sur un côté d'une partie qui relie le mécanisme à engrenages de rotation de buse (47) et le mécanisme d'entraînement d'axe Q (20), en fournissant un mécanisme de pincement (43) qui pince la portion de projection de positionnement (53) dans un élément de liaison (42) sur l'autre côté, et en pinçant la portion de projection de positionnement (53) par le mécanisme de pincement (43), le mécanisme de pincement (43) comprenant un galet de référence (44) dont la position est fixée, un galet mobile (45) dont un intervalle avec le galet de référence (44) est changé, et une unité de contrainte (40) qui contraint le galet mobile (45) en direction du galet de référence (44), et la portion de projection de positionnement (53) est pincée entre le galet de référence (44) et le galet mobile (45), l'élément de liaison (48) du mécanisme à engrenages de rotation de buse (47) est relié à l'élément de liaison (42) du mécanisme d'entraînement d'axe Q (20) en direction de rotation en éliminant le jeu.

2. Machine de montage de composants selon la revendication 1, comprenant en outre :
un pied de placement de tête rotative (60) qui place une tête rotative (11) pour son remplacement ; et
une caméra (58) qui est déplacée par le mécanisme de déplacement de tête (55),
dans laquelle un dispositif de contrôle (56), qui contrôle le fonctionnement de la machine de montage de composants, capture avec la caméra (58) l'image de la portion de projection de positionnement (53) ou du mécanisme de pincement (43) de la tête rotative (11) qui est placé sur le pied de placement de tête rotative (60), reconnaît la position de la portion de projection de positionnement (53) ou du mécanisme de pincement (43), aligne la portion de projection de positionnement (53) et le mécanisme de pincement (43) sur base du résultat de reconnaissance, et relie l'unité d'entraînement (41) et la tête rotative (11).

3. Machine de montage de composants selon l'une quelconque des revendications 1 et 2,
dans laquelle le mécanisme à engrenages de rotation de buse (47) fait tourner chaque support de buse (12) en engrenant un engrenage cylindrique (48) qui est monté de manière à pouvoir être tourné par la tête rotative (11) et de petits engrenages (49) qui sont attachés respectivement à chaque support de buse (12), et en faisant tourner les petits engrenages (49) de chaque support de buse (12) par rotation de l'engrenage cylindrique (48) à l'aide du mécanisme d'entraînement d'axe Q (20) de l'unité d'entraînement (41).

4. Machine de montage de composants selon l'une quelconque des revendications 1 à 3,
dans laquelle l'unité d'entraînement (41) comprend un mécanisme d'entraînement d'axe Z (28) qui abaisse le support de buse (12) qui est tourné jusqu'à une position prédéterminée par la rotation de la tête rotative (11).
